# EUROPEAN PATENT SPECIFICATION

(11) **EP 0 258 859 B1**
(45) Date of publication and mention of the grant of the patent: **07.08.1996**
(21) Application number: 87112650.4
(22) Date of filing: 31.08.1987
(51) Int. Cl.: C08J 5/18, B29D 7/01

(54) **Polyimide film and its manufacturing method**
Polyimidfolie und Verfahren zu deren Herstellung
Film de polyimide et méthode pour sa fabrication

(30) Priority: 01.09.1986 JP 205576/86; 01.09.1986 JP 205577/86
(43) Date of publication of application: 09.03.1988
(73) Proprietor: KANEGAFUCHI KAGAKU KOGYO KABUSHIKI KAISHA, Kita-ku Osaka-shi Osaka-fu 530 (JP)
(72) Inventor: Nojiri, Hitoshi, Ohtsu-shi Shiga-ken (JP); Kitai, Katuhiro, Ohtsu-shi Shiga-ken (JP); Ohnari, Yishihide, Ohtsu-shi Shiga-ken (JP); Kidoh, Masaro, Ohtsu-shi Shiga-ken (JP); Yamamoto, Tsuneo, Kobe-shi Hyogo-ken (JP)
(74) Representative: VOSSIUS & PARTNER

(56) References cited:
- EP-A- 0 087 305
- EP-A- 0 125 599
- FR-A- 2 109 447
- GB-A- 1 098 556
- US-A- 3 455 774
- US-A- 3 485 734

## Description

The present invention relates to a heat reistant polyimide film and its manufacturing method and, more particularly, to a polyimide film whose adhesion performance is improved by substantially reducing the content of residual volatiles as compared with that of conventional polyimide films, and further, in addition to the reduction of the content of residual volatiles, by controlling the oxygen/carbon ratio of the surface layer, and the manufacturing method thereof.

Polyimide films are known for their outstanding properties such as high heat resistance, cold resistance, resistance to chemicals, electrical insulation performance and mechanical strength, and are widely used as electric insulation film, heat insulation film and base film for flexible printed circuit boards (PCB). In its principal field of application e.g. as material of PCB or electric insulation film, the film is often bonded to a copper foil with the aid of a proper adhesive, or is used as a material of prepreg which is prepared by coating with an adhesive or conjugating with a fluorine resin. Hence great importance is given to its adhesion performance.

Hitherto, as adhesion performance-improving techniques for high-polymer-films such treating methods as flame treatment, corona discharge treatment, ultraviolet ray treatment, alkali treatment, primer treatment and sandblast treatment have been known. For the treatment of polyimide films, too, common methods which can satisfy the purposes of a heat resistant film such as sandblast or alkali treatment have been used.

All these methods are, however, intended for improving the adhesion performance by after-treatment of commercialized films. Thus, none of these methods is applicable to the films in the process of manufacture or film forming for improving their adhesion performance. Hence there have been sometimes problems with an uneven adhesion performance of the films before after-treatment as well as with the stability of the after-treating method and homogeneity of the film to be treated, and it has been basically difficult to supply stably films of improved adhesion performance. Moreover, commercialization of such a process requires a large amount of investment, this inevitably resulting in a rise of manufacturing cost. The same is the case with a film made by conjugation with e.g. a fluorine resin, and it has been difficult to stably realize a film of high peeling strength by any of the conventional techniques.

It is a primary object of the present invention to provide stably a polyimide film of improved homogeneity and adhesion performance.

Another object of the invention is to provide a polyimide film improved in adhesion performance on both sides.

Still another abject of the invention is the provision of a polyimide film manufacturing method which improves the adhesion performance of the polyimide film in the process of film forming.

In view of such current situation, the present inventors, after intensive research for accomplishing the above-mentioned objects, have discovered that a polyimide film of improved adhesion performance is obtainable by reducing the content of residual volatiles as compared with that of conventional polyimide films and by controlling the oxygen/ carbon ratio of the surface layer, besides the reduction of the content of residual volatiles.

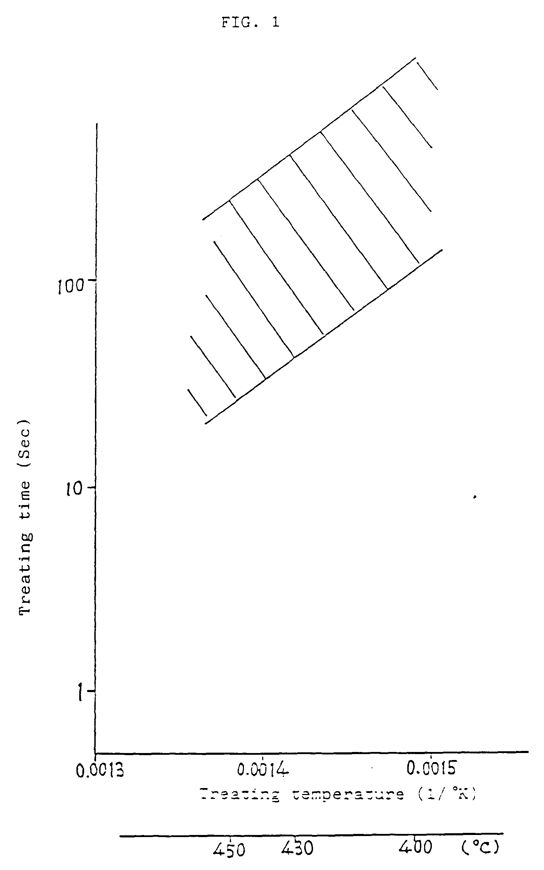

Fig. 1 is a graph showing the relationship between heat-treating temperature and heat-treating time.

The first embodiment of the present invention is the provision of an improved polyimide film, the content of residual volatiles of which is reduced to not more than 0.45 weight %, based on the weight of the film, and the oxygen/carbon ratio of the surface of the film is increased by 0.01-0.1 compared with an untreated film, said content of residual volatiles being defined by the following formula:${\text{Residual content of volatiles (%) = [(W}}_{\text{o}} {\text{-W)/W}}_{\text{o}} \text{] x 100}$ where
- Wₒ:: Weight after drying for 10 min at 150 °C
- W:: Weight after heat treatment for 20 min at 450 °C.

The second embodiment is the provision of a manufacturing method which comprises heating a polyimide film at a temperature of not lower than 300 °C to reduce its content of residual volatiles to not more than 0.45 weight % based on the weight of the film, and then treating the polyimide film with a corona discharge or a plasma.

The present inventors recognized that conventional polyimide films, manufactured by the so-called solvent cast method, have a brittle and mechanically weak surface layer, which adversely affects the adhesion performance of the film. They made an extensive study to effectively improve the film in this respect. It can be understood that the currently practiced sandblast treatment and alkali treatment are both aimed at removing this brittle and weak surface layer. Besides of the removal of this surface layer, however, great effort was made also to reform the film as a whole, and as a result it was discovered that the adhesion performance of the film largely depends on the content of residual volatiles of the entire film.

To evaluate the adhesion performance, various solvent-based adhesives were used, and the film coated with the adhesive was dried and then heat-laminated. Considering that a large variety of solvents were used for this purpose, it is quite remarkable that it was discovered that the adhesion performance of the film largely depends on the content of residual volatiles. Also discovered was the fact that the adhesion performance of the film can be improved by controlling the content of residual volatiles others than those attributable to the adhesive used, which are not necessarily removed when removing the surface layer.

In the present invention, the content of residual volatiles in the film excludes only water, and is defined by the following formula:$\text{Residual content of volatiles (%)} {\text{= [(W}}_{\text{o}} {\text{- W)/ W}}_{\text{o}} \text{] x 100}$ where
- Wₒ:: Weight after drying for 10 min. at 150 °C
- W :: Weight after heat treatment for 20 min. at 450 °C

The polyimide film of the present invention has a content of residual volatiles of not more than 0.45 weight % based on the weight of the film. If this limit is exceeded, it is difficult to obtain a film which is satisfactory in adhesion performance. Preferably, the said content may be within a range of 0.15-0.4 weight %. A content of less than 0.15 weight % may occasionally be undesirable, because it may adversely affect the mechanical properties.

The polyimide film of the present invention is obtainable from a variety of known materials, and there is no limitation in this respect. Considering the balance of the properties of the film, a polyimide film consisting of poly-[N,Nʹ-P,Pʹ-oxydiphenylene-pyromellit]-imide is preferred. For the production of the polyimide film an imidizing agent may be used (chemical cure method) or only heat can be applied (dry-up method). The chemical cure method is preferred for it gives a better result.

The thickness of the polyimide film of the present invention is not specifically limited, but it may preferably be in the range of 10-125µm, and more preferably 50-125µm.

The effect of the present invention is particularly remarkable when the film is moe than 50 µm thick. The conventional polyimide film had the disadvantage of requiring a laborious and costly after-treatment for improving its adhesion performance and, worse, it was difficult to attaim said effect on both sides of the film. By contrast, the present invention readily achieves this improvement on both sides of the film.

As a specific example for reducing the content of residual volatiles in the film to not more than 0.45 weight % a method involving a heat treatment is given.

The method consists in carrying out a heat treatment for a necessary time at a temperature of not lower than 300°C. The necessary time and temperature can be readily set within the range required for attaining the objects of the present invention. A preferred and effective range is shown in Fig. 1 within the parallel, diagonal lines.

The conditions of the heat treatment of the present invention are set for the manufacturing process with its maximum temperature, but the treatment has not necessarily to be carried out within the manufacturing process. It is as well possible to perform it in a separate process.

In the present invention, the adhesion performance may be much more enhanced by increasing the oxygen/carbon ratio in the surface layer of the film by 0.01 to 0.1, preferably 0.02 to 0.08, as compared with the conventional polyimide film.

The increase of the oxygen/carbon ratio in the surface layer of the film referred to in connection with the present invention can be shown by the difference between the oxygen/carbon ratio in the surface layer of the film and that of a polished surface layer of the film, which may be determined by the use of XPS.

As specific examples for increasing the oxygen/carbon ratio in the surface layer of the film the corona discharge and plasma-treating processes are given. The corona treatment is preferred because the plasma treatment requires a large investment in facilities. With the corona discharge treatment the object of the present invention can easily be accomplished with respect to both one-side and two-side treatment as well as partial treatment of the surface. Also a proper setting of the treating level and frequency or times of the treatment can easily be controlled. Recommended conditions are, for instance, 10-1,000 W/m²/min, and preferably 30-600 W/m²/min.

The method of the present invention for controlling the content of residual volatiles in the film and for controlling the oxygen/carbon ratio as well as the content of residual volatiles in order to improve its adhesion performance, generally renders the known after-treating methods superfluous. If it is desirable it may however also be carried out in combination with any of these methods.

As to the adhesion performance of a polyimide film, there has been no report concerning the relationship between the adhesion performance and the content of residual volatiles in the film. The present inventors discovered, for the first time, the possibility of improving the adhesion performance by controlling the content of residual volatiles and the oxygen/carbon ratio in the film. Although the mechanism is not yet entirely understood, it is presumed that the improvement is due to the removal of volatiles affecting the adhesion performance of the film in the process of reducing the content of residual volatiles to 0.45 weight % or below. Probably within the residual volatiles substances are contained which retard the effect of the treatment for increasing the oxygen content of the surface layer, and the effect of the present invention is further improved by reducing the amount of or by even eliminating these substances together with the residual volatiles.

By the use of the present invention, it is possible to directly impart a good adhesion performance to the film, which has been considered difficult. While polyimide films excellent in adhesion performance on both sides have not yet been provided, the present invention makes the improvement of the adhesive performance on both sides of the film easy. Further, since no after-treatment is necessary, there is no need for a separate process. This is advantageous not only with respect to the required investment for the equipment but also with respect to overcome the instability of the known process which gave rise to alterations or even loss of the adhesion performance caused by the after-treating methods. The process of the invention thus is extremely advantageous and cheap. Using the present invention, it is possible to attain a high level of adhesion performance which cannot be achieved by any of the known surface treatting methods. Also, according to the present invention, it is possible to impart a good adhesion performance to films having a thickness of 50-125 µm for which none of the conventional methods was effective. With the present invention, it is further possible to stably improve the peeling strength of composite films made by conjugation with a fluorine resin.

The present invention is now further illustrated by the following non-limiting examples.

### Control example 1

A polyimide film having a thickness of 50 µm was prepared from pyromellitic acid dianhydride and 4,4'-diamino-diphenyl ether and its adhesive strength and elongation at break were measured. The results are shown in Table 1.

### Examples 1-3

A polyimide film having a thickness of 50 µm was prepared from pyromellitic acid dianhydride and 4,4'-diaminodiphenyl ether. The film was heat-treated for reducing its content of residual volatiles. Both sides of the resulting film were then treated by the corona discharge process under the conditions of 200 W/m²/min.

The content of residual volatiles, the increase of the oxygen/carbon ratio of the surface layer of the film and its adhesion performance were measured. The results are shown in Table 1.

Table 1 reveals that the adhesion performance was improved to such a degree that breakage took place between the adhesive and the copper foil.

### Control Examples 2-4

A polyimide film having a thickness of 50 µm was prepared in the same way as in Examples 1-3. The results of the measurements of adhesive strength etc. are shown in Table 1 as that of Control Example 2.

Further, the film of Control Example 2 was corona discharge-treated once and 10 times respectively and the adhesive strength was measured. The results are shown in Table 1 as those of Control Examples 3 and 4.

The results in Table 1 indicate that the adhesion strength in Control Examples 2-4 is insufficient or much less impressive, even if it is increased. It is also apparent that the adhesion performance of the film of Control Example 4 is unsatisfactory even after a repeated after-treatment. Moreover, in Control Example 1, the adhesion performance is satisfactory but elongation is not always perfect.

### Examples 4-6

A polyimide film having a thickness of 75 µm was prepared in the same way as in Examples 1-3.

The film was heat-treated for 1 minute at 450°C, and then further treated by the corona discharge and plasma processes to prepare films having a different degree of increase in the oxygen/carbon ratio of its surface layer. The adhesive strength and elongation at break were measured and the results are shown in Table 1. It is apparent that the present invention enables the preparation of films highly improved in adhesion performance.

### Control Examples 5-7

A polyimide film having a thickness of 75 µm was prepared in the same way as in Examples 4-6 and its adhesive strength was measured. The result is shown in table 1 as that of Control Example 5.

The film was corona discharge-treated once and 20 times, respectively, under the conditions of 400 W/m²/min and the results are shown in Table 1 as those of Control Examples 6 and 7. It is apparent that the result is unsatisfactory compared with that attainable by the present invention.

**Table 1**

| | Content of residual volatiles (Wt.%) | Increase of 0x./C ratio | Adhesion strength | | Elongation at break | |
|---|---|---|---|---|---|---|
| | | | A-side | B-side | MD | TD |
| Ex. 1 | 0.11 | 0.050 | A11 C/A | A11 C/A | 81 | 78 |
| Ex. 2 | 0.28 | 0.039 | A11 C/A | 2.5 4/6 | 89 | 84 |
| Ex. 3 | 0.44 | 0.055 | 2.4 5/6 | 2.3 3/6 | 86 | 91 |
| C.Ex. 1 | 0.05 | 0.000 | A11 C/A | A11 C/A | 56 | 61 |
| C.Ex. 2 | 0.55 | 0.000 | 1.3 | 1.0 | 85 | 80 |
| C.Ex. 3 | 0.53 | 0.038 | 1.0 | 1.1 | 92 | 88 |
| C.Ex. 4 | 0.56 | 0.042 | 1.5 | 1.6 | 93 | 85 |
| Ex. 4 | 0.40 | 0.022 | 2.3 2/6 | 2.4 3/6 | 92 | 93 |
| Ex. 5 | 0.38 | 0.075 | 2.5 4/6 | 2.4 3/6 | 86 | 89 |
| Ex. 6 | 0.37 | 0.090 | 2.7 5/6 | A11 C/A | 90 | 91 |
| C.Ex. 5 | 0.52 | 0.000 | 0.6 | 0.7 | 95 | 87 |
| C.Ex. 6 | 0.50 | 0.045 | 0.7 | 0.7 | 92 | 95 |
| C.Ex. 7 | 0.53 | 0.060 | 1.3 | 1.4 | 92 | 89 |

### Examples 7-10

Polyimide films having a thickness of 50 µm were prepared in the same way as in Examples 1-3 from different starting materials and the content of residual volatiles, the increase in oxygen/carbon ratio of the surface layer and the adhesive strength were determined. The results are shown in Table 2.

From the data in Table 2, it is apparent that the present invention affords films of high adhesion performance.

**Table 2**

| | Acid anhydride | Diamine | Content of residual volatiles (wt.%) | Increase of 0x/C ratio | Adhesion strength | |
|---|---|---|---|---|---|---|
| | | | | | A-side | B-side |
| Ex. 7 | PMDA | PPD | 0.326 | 0.032 | 2.5 4/6 | 2.4 3/6 |
| Ex. 8 | BPDA | ODA | 0.382 | 0.045 | 2.4 3/6 | 2.4 3/6 |
| Ex. 9 | BPDA | PPD | 0.431 | 0.035 | 2.3 2/6 | 2.5 2/6 |
| Ex. 10 | PMDA | PPD1/ODA4 | 0.237 | 0.029 | 2.5 5/6 | 2.3 5/6 |
| Note (1) PMDA: Pyromellitic acid dianhydride BPDA: 3,3',4,4'-biphenyltetracarboxylic acid dianhydride PPD: Paraphenylene diamine ODA: 4,4'-diaminodiphenyl ether | | | | | | |
| Note (2) FPD1/ODA4 means a ratio of 4 mols of ODA to 1 mol of PPD. | | | | | | |

### Example 11

A surface-treated FEP-film having a thickness of 12.5 µm was hot laminated on one side of the polyimide film of Example 2 having a thickness of 50 µm to obtain a composite film, and it was then heat-sealed "FEP on FEP".

A T-peeling test was carried out at a test speed of 300 mm/min. The result was an excellent peeling strength of 400 g/1.27 cm (0.5 inch) width.

### Control Example 8

The peeling strength of the polyimide film of Control Example 2 was measured in the same way as described in Example 11. The result was 300 g/1.27 cm (0.5 inch) width.

## Claims

1. A polyimide film having a content of residual volatiles of not more than 0.45 weight % based on the weight of the film and an oxygen/carbon ratio of the surface of the film which is increased by 0.01-0.1 compared with an untreated film, said content of residual volatiles being defined by the following formula:${\text{Residual content of volatiles (%) = [(W}}_{\text{o}} {\text{-W)/W}}_{\text{o}} \text{] x 100}$ where
Wₒ: Weight after drying for 10 min at 150 °C
W: Weight after heat treatment for 20 min at 450 °C,
obtainable by heat-treating a polyimide film at a temperature of not lower than 300 °C and then treating it with a corona discharge or a plasma.

2. A polyimide film in accordance with claim 1, wherein the film consists of poly-(N,N'-P,P'-oxydiphenylenepyromellit)-imide.

3. A polyimide film in accordance with claim 1 or 2, wherein thethickness of the film is in a range of 10-125 µm.

4. A polyimide film in accordance with claim 3, wherein the thickness of the film is in a range of 50-125 µm.

5. A method for manufacturing a polyimide film according to claims 1 to 4 characterized in that a polyimide film is heat-treated at a temperature of not lower than 300°C to reduce its content of residual volatiles to not more than 0.45 weight % based on the weight of the film, and then treated with a corona discharge or a plasma.

6. The method in accordance with claim 5, wherein the corona discharge treatment is carried out under conditions of 10-1,000 W/m²/min.

7. The method in accordance with claim 6, wherein the corona discharge treatment is carried out under conditions of 30-600 W/m²/min.

8. The method in accordance with claim 5, wherein the film is produced by a chemical curing method using an imidizing agent.

## Patentansprüche

1. Polyimidfolie mit einem Restgehalt an flüchtigen Bestandteilen von höchstens 0,45 Gew.-%, bezogen auf das Gewicht der Folie, und mit einem Sauerstoff/Kohlenstoff-Verhältnis der Folienoberfläche, welches, verglichen mit einer unbehandelten Folie, um 0,01-0,1 vergrößert ist, wobei der Restgehalt an flüchtigen Bestandteilen durch die nachstehende Formel definiert ist:${\text{Restgehalt an flüchtigen Bestandteilen (%) = [(W}}_{\text{0}} {\text{- W) / W}}_{\text{0}} \text{] x 100}$ wobei
W₀ : Gewicht nach 10-minütigem Trocknen bei 150°C
W : Gewicht nach 20-minütiger Heißbehandlung bei 450°C
erhältlich durch Heißbehandeln einer Polyimidfolie bei einer Temperatur von mindestens 300°C und anschließendes Behandeln derselben mit einer Coronaentladung oder einem Plasma.

2. Polyimidfolie nach Anspruch 1, wobei die Folie aus Poly-(N,N'-P,P'-oxydiphenylenpyromellith)-imid besteht.

3. Polyimidfolie nach Anspruch 1 oder 2, wobei die Dicke der Folie in einem Bereich von 10 - 125 µm liegt.

4. Polyimidfolie nach Anspruch 3, wobei die Dicke der Folie in einem Bereich von 50-125 µm liegt.

5. Verfahren zur Herstellung einer Polyimidfolie nach den Ansprüchen 1 bis 4, dadurch gekennzeichnet, daß eine Polyimidfolie zur Verringerung ihres Restgehaltes an flüchtigen Bestandteilen auf höchstens 0,45 Gew.-%, bezogen auf das Gewicht der Folie, bei einer Temperatur von mindestens 300°C heißbehandelt wird und danach mit einer Coronaentladung oder einem Plasma behandelt wird.

6. Verfahren nach Anspruch 5, wobei die Coronaentladungsbehandlung unter Bedingungen von 10 - 1000 W/m²/Min. ausgeführt wird.

7. Verfahren nach Anspruch 6, wobei die Coronaentladungsbehandlung unter Bedingungen von 30 - 600 W/m²/Min, ausgeführt wird.

8. Verfahren nach Anspruch 5, wobei die Folie in einem chemischen Aushärteverfahren unter Verwendung eines Imidisierungsmittels hergestellt wird.

## Revendications

1. Film de polyimide ayant une teneur en résidus volatils non supérieure à 0,45% en poids par rapport au poids du film et un rapport oxygène/carbone de la surface du film qui est augmenté de 0,01-0,1 par comparaison avec un film non traité, ladite teneur en résidus volatils étant définie par la formule suivante :${\text{teneur résiduelle en volatils (%) = [(W}}_{\text{0}} {\text{- W)/W}}_{\text{0}} \text{] x 100}$
où W₀ : poids après séchage pendant 10 minutes à 150°C
W : poids après traitement à la chaleur pendant 20 minutes à 450°C,
susceptible d'être obtenu par traitement à la chaleur d'un film de polyimide à une température non inférieure à 300°C et ensuite en le traitant avec une décharge lumineuse ou un plasma.

2. Film de polyimide selon la revendication 1, dans lequel le film consiste en poly-(N,N'-P,P'-oxydiphénylènepyromellit)-imide.

3. Film de polyimide selon la revendication 1 ou 2 dans lequel l'épaisseur du film est dans l'intervalle de 10-125 µm.

4. Film de polyimide selon la revendication 3 dans lequel l'épaisseur du film est dans l'intervalle de 50-125 µm.

5. Procédé de fabrication d'un film de polyimide selon les revendications 1 à 4 caractérisé en ce qu'un film de polyimide est traité à la chaleur à une température non inférieure à 300°C pour réduire sa teneur en résidus volatils à pas plus de 0,45% en poids par rapport au poids du film et ensuite traité avec une décharge lumineuse ou un plasma.

6. Procédé selon la revendication 5 dans lequel le traitement par décharge lumineuse est effectué dans des conditions de 10-1 000 W/m²/min.

7. Procédé selon la revendication 6 dans lequel le traitement par décharge lumineuse est effectué dans des conditions de 30-600 W/m²/min.

8. Procédé selon la revendication 5 dans lequel le film est produit par un procédé de cuisson chimique utilisant un agent imidisant.
